# EUROPÄISCHE PATENTSCHRIFT

(11) **EP 1 258 920 B1**
(45) Veröffentlichungstag und Bekanntmachung des Hinweises auf die Patenterteilung: **26.03.2008**
(21) Anmeldenummer: 02010016.0
(22) Anmeldetag: 04.05.2002
(51) Int. Cl.: H01L 21/762, H01L 21/74, H01L 21/20

(54) **Verfahren zur Herstellung vergrabener Bereiche**
Method of manufacturing buried regions
Procédé de formation de régions enterrées

(30) Priorität: 16.05.2001 DE 10124038
(43) Veröffentlichungstag der Anmeldung: 20.11.2002
(73) Patentinhaber: ATMEL Germany GmbH, 74072 Heilbronn (DE)
(72) Erfinder: Dietrich, Harry, 74912 Kirchardt (DE); Dudek, Volker, Dr., 74336 Brackenheim (DE); Schüppen, Andreas, Dr., 74348 Lauffen (DE)
(74) Vertreter: Müller, Wolf-Christian

(56) Entgegenhaltungen:
- EP-A- 0 494 598
- EP-A- 0 936 663
- US-A- 5 444 014
- US-A- 5 496 764
- "SILICON-ON-INSULATOR VERTICAL COMPLEMENTARY BIPOLAR DEVICE STRUCTURE" IBM TECHNICAL DISCLOSURE BULLETIN, IBM CORP. NEW YORK, US, Bd. 34, Nr. 4A, 1. September 1991 (1991-09-01), Seiten 166-170, XP000210871 ISSN: 0018-8689
- PATENT ABSTRACTS OF JAPAN Bd. 2000, Nr. 09, 13. Oktober 2000 (2000-10-13) & JP 2000 183157 A (HYUNDAI ELECTRONICS IND CO LTD), 30. Juni 2000 (2000-06-30) -& US 6 242 320 B1 (SO SANG MUN) 5. Juni 2001 (2001-06-05)

## Beschreibung

Die vorliegende Erfindung betrifft ein Verfahren zur Herstellung vergrabener Bereiche auf einem Wafer mit isolierender Zwischenschicht, gemäß dem Oberbegriff des Patentanspruchs 1.

Ein derartiges Verfahren ist aus der Druckschrift H.S.Gamble, in Perspectives, Science an Technologies for Novel Silicon on Insulators Devices, 2000, bekannt. Ausgehend von einem Wafer, der eine ganzflächige Oxidschicht und eine darauf aufliegende ganzflächige Silizidschicht aufweist, wird ein Wafer mit einer vergrabenen Silizidschicht und einer darunter liegenden isolierenden Zwischenschicht (SOI-Wafer) erzeugt, indem die Oberfläche der Silizidschicht mit der Oberfläche eines weiteren Silizium-Wafer mittels Wafer-Bonding zusammengefügt wirdNach dem Zusammenfügen der Oberflächen wird der Silizium-Wafer mittels weiterer Prozeßschritte gedünnt, um eine Siliziumschicht zu erzeugen, in der durch weitere Prozeßschritte Bauelemente hergestellt werden. Um die Silizidschicht zu strukturieren und einzelne von einander isolierte Siliziumbereiche (Boxen) zu erzeugen, wird mittels eines Trenchprozesses die gedünnte Siliziumschicht und die darunterliegende Silizidschicht durchgeätzt. Der Trenchprozeß stoppt dabei auf der unter der Silizidschicht liegenden Oxidschicht.

Nachteilig an dem beschriebenen Verfahrens ist es, daß auf einem SOI-Wafer eine ganzflächige Silizidschicht vergraben wird, die mittels eines Trenchprozesses strukturiert werden muß, bei dem unter anderem Metallionen freigesetzt werden, die in geringsten Spuren die Bauelementeigenschaften verschlechtern. Insbesondere bei größeren Dicken der obersten Siliziumschicht ist dies mit vertretbarem Aufwand nicht möglich. Ferner entstehen bei Kontaktflächen und bestimmten Bauelementen, wie beispielsweise MOS-Transistoren, unerwünschte parasitäre Kapazitäten, die eine Verwendung des SOI-Wafers zur Herstellung von integrierten Schaltungen sehr behindern. Ferner führt der unterschiedliche Ausdehnungskoeffizienten der Silizidschicht im Vergleich zu dem Trägermaterial zu Verspannungen, die den Wafer je nach Temperaturprozess den SOI-Wafer krümmen oder Versetzungen in der aktiven Siliziumschicht erzeugen. Des Weiteren verursachen gekrümmte Wafer einen erheblichen Aufwand in den Lithographiemodulen. Zusätzlich besteht bei dem Verfahren die Schwierigkeit, einen Kollektor für einen vertikalen bipolaren Transistor herzustellen, da hierzu der zum Bonden verwendete Silizium-Wafer ebenfalls vor dem Zusammenfügen prozessiert werden muß. Ein weiterer Nachteil ist, daß bei dem Zurückschleifen des Wafers die Toleranz der Schichtdicke der obersten Siliziumschicht nur mit großem Aufwand klein gehalten werden kann. Ferner sind nach dem Schleifen aufwendige Reinigungs- und Polierschritte notwendig, um eine vertretbare Oberflächenqualität zu erhalten.

Da SOI-Wafer für die Herstellung von integrierten Schaltungen wesentliche Vorteile gegenüber herkömmlichen Silizium Substraten bieten, wie beispielsweise die völlige Unterdrückung von Substratströmen und sofern keine vergrabenen ganzflächigen Metallschichten vorhanden sind, geringste parasitäre Kapazitäten aufweisen, werden im Bereich der Halbleitertechnik zunehmend Wafer mit einer isolierenden Zwischenschicht als Ausgangsmaterial für die Produktion von integrierten Schaltungen verwendet. Ferner können bei SOI-Wafer mittels einer Trench-Technologie einzelne vollständig voneinander isolierte Bauelementboxen hergestellt werden, die auf einem unterschiedlichen elektrischem Potential liegen können. Um besondere Bauelementeigenschaften auf einem SOI-Wafer zu kombinieren, ist es ein Ziel der Entwicklung in diesem Gebiet, mittels dem Vergraben von räumlich begrenzten Schichten, im Folgenden Bereiche genannt, wie beispielsweise Siliziden, für bestimmte Gattungen von Bauelementen extrem niedrige Anschlußwiderstände zu erreichen, während für andere Gattungen von Bauelementen, die sehr kleinen parasitären Kapazitäten des isolierenden Zwischenschicht erzielt werden.

Aus der US 5,444,014 ist ein Herstellungsverfahren zur Fabrikation eines SOl-Substrates bekannt. Zur Ausbildung des SOl-Substrates werden zwei Siliziumwafer aneinander gebondet. Aus der EP 0 494 598 A1 ist ein Prozessverfahren für ein Halbleitersubstrat bekannt. Eine vergrabene Silizidschicht dient als Leiter für einen Dotierstoff zur horizontalen Verteilung desselben.

Aufgabe der vorliegenden Erfindung ist es, ein Verfahren anzugeben, mit dem sich vergrabene Bereiche auf einem Wafer mit einer isolierenden Zwischenschicht einfach und kostengünstig herstellen lassen.

Die erstgenannte Aufgabe wird durch die Merkmale des Patentanspruches 1 gelöst. Günstige Ausgestaltungsformen sind Gegenstand von Unteransprüchen.
Demzufolge ist ein Verfahren zur Herstellung eines Silizium-Wafers vorgesehen, wobei ein erster Silizium-Wafer, der einen Träger, eine auf dem Träger angeordnete isolierende Zwischenschicht, insbesondere eine Siliziumoxidschicht, und eine an die Zwischenschicht anschließende Oberflächenschicht, insbesondere Silizium, umfasst, und ein zweiter Silizium-Wafer, der eine Oberfläche aufweist, über ihre jeweilige Oberfläche zusammengefügt werden (bonden).

Vor dem Zusammenfügen werden auf dem ersten Wafer innerhalb oder auf der Oberfläche der Oberflächenschicht, Bereiche mit veränderten Schichteigenschaften erzeugt, die sich in wenigstens einer charakteristischen Schichteigenschaft von den diese Bereiche umgebenden Gebiete unterscheiden.

Anschließend wird auf der Oberfläche wenigstens eines Silizium-Wafers wenigstens eine isolierende Schicht, insbesondere Siliziumoxid, aufgebracht. Nach dem Zusammenfügen der beiden Silizium-Wafer wird der Träger des ersten Silizium-Wafers entfernt.

In einer Weiterbildung des Verfahrens ist es vorteilhaft, den Träger des ersten Silizium-Wafers selektiv zu der isolierenden Zwischenschicht zu entfernen, da eine selektive Entfernung mittels robuster und vergleichsweisen kostengünstigen Prozeßschritten, wie beispielsweise durch einen naßchemischen Prozeß durchführbar ist. In einem nachfolgenden Prozeßschritt wird durch die Abnahme; die sich auch bereichsweise und oder schrittweise durchführen läßt, die isolierende Zwischenschicht des ersten Wafers, die bisherige Grenzfläche Silizium-Isolierende Schicht, die vor dem Zusammenfügen vergraben war, als neue Silizium-Oberfläche bereitgestellt. Sofern die isolierende Zwischenschicht nur bereichsweise entfernt wird, kann diese auch für weitere Prozeßschritte, beispielsweise als Maske, verwendet werden.

Ein Vorteil des neuen Verfahrens gegenüber dem bisherigen Stand der Technik ist, daß auf dem ersten Wafer, vor dem Zusammenfügen die Parameter von einzelnen Bereichen in der obersten Siliziumschicht für die jeweilige Gattung von Bauelementen sich optimieren lassen, ohne daß damit die Parameter der ganzen Schicht geändert werden. Ferner wird die Oberfläche von der ersten Siliziumschicht, die aus der Herstellung des ersten Wafers eine hohe Qualität aufweist, für weitere Fertigungsschritte, mit denen beispielsweise die Bauelemente von integrierten Schaltungen hergestellt werden, nutzbar gemacht, ohne daß eine Nachbearbeitung der obersten Siliziumschicht durchgeführt wird, um die Schichtqualität zu optimieren. Dabei ist das neue Verfahren unabhängig von der Dicke der ersten Schicht auf dem ersten Silizium-Wafer. Insbesondere bei dickeren Schichten wird die Anforderung an die Qualität der Oberfläche, wie beispielsweise die Gleichmäßigkeit der Schichtdicke, verringert, da auf diese Oberfläche eine isolierende Schicht abgeschieden wird und durch das erneute Zusammenfügen mit einem weiteren Wafer die Oberfläche als Grenzfläche Silizium-Isolationsschicht vergraben wird. Da der Träger und die isolierende Schicht des ersten Wafers entfernt werden, werden an den Aufbau und die Qualität dieser Schichten nur geringe Anforderungen gestellt. Ferner dient bei einer selektiven Abnahme des Träges die Zwischenschicht nur als Stopschicht und entsprechend kann die Dicke der isolierenden Schicht sehr gering sein und beispielsweise auch Werte unterhalb 0.1 µm aufweisen. Durch die geringen Anforderungen an den Herstellungsprozeß des ersten Wafers werden die thermische Belastung und der Streß durch die Oxidation weitestgehend reduziert.

In einer Weiterbildung des Verfahrens wird, vor dem Zusammenfügen der beiden Wafer, in vorgegebenen Bereichen der obersten Siliziumschicht des ersten Wafers, die Leitfähigkeit geändert, indem beispielsweise mittels Implantation und/oder Diffusion ein Dotierstoffeintrag durchgeführt wird. Damit lassen sich insbesondere für bipolare Transistoren die elektrischen Eigenschaften der Kollektorgebiete einstellen. Ferner lässt sich, mittels eines Epitaxieprozesses, die Schichtdicke der Siliziumschicht lokal oder global erhöhen und dabei ein vertikaler Dotiergradient erzeugen. Durch die Kombination von den verschiedenen Prozessschritten lassen sich die elektrischen Eigenschaften insbesondere im bipolaren Bereich optimieren.

In einer anderen Weiterbildung des Verfahrens werden, um einen besonders niedrigen Schichtwiderstand zu erreichen, vor dem Zusammenfügen in der obersten Siliziumschicht des ersten Wafers silizidierte Bereiche erzeugt. Neben der Bildung eines Titan- oder Nickelsilizids bietet sich hier vorzugsweise die Bildung eines Kobaltsilizides an, da es eine besonders hohe Temperaturstabilität aufweist. Hierbei ist es vorteilhaft, die Bereiche der Schicht in denen kein Silizid gebildet werden soll, durch eine Oxidmaske zu schützen und die Dicke der Oxidschicht an die Enddicke des Silizides derart anzupassen, daß die Oxidschicht mit der Silizid-Schicht eine planare Fläche bildet.

In einer anderen Weiterbildung des Verfahrens wird die Silizidschicht mit einer Oxidschicht abgedeckt, um das Zusammenfügen mit dem zweiten Wafer zu erleichtern. Sofern erforderlich, läßt sich eine ausreichende Planarität mittels eines kurzen Polierschrittes erzeugen. Die Oxidschicht, deren Dicke beispielsweise oberhalb 0.5µm liegt, wird, um das thermische Budget klein zu halten, vorzugsweise durch eine Abscheidung erzeugt. Es ist dabei vorteilhaft, die Oxidschicht nach dem Zusammenfügen als isolierende Zwischenschicht zu verwenden und deren Dicke an die Bauelementeigenschaften anzupassen.

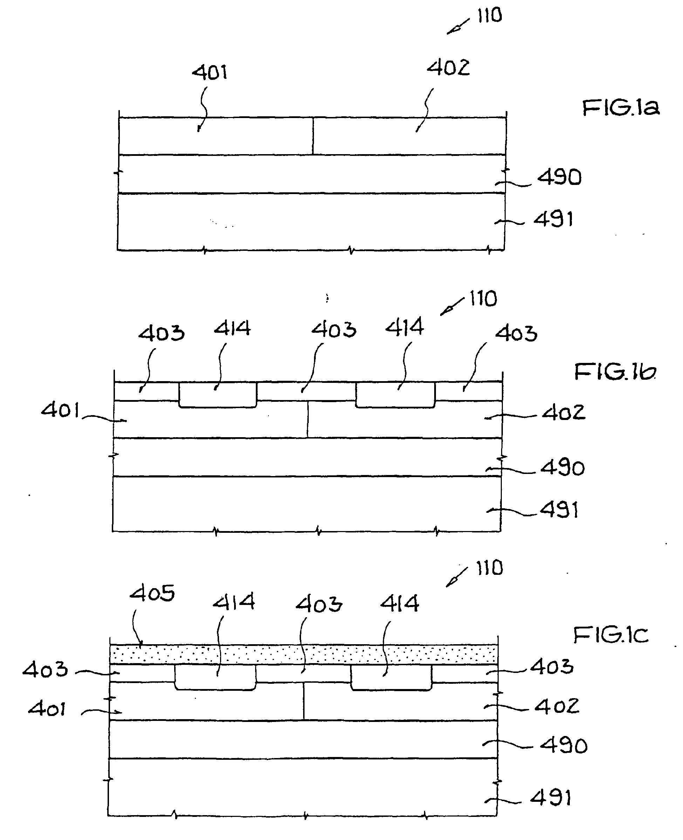

Das erfindungsgemäße Verfahren soll nachfolgend anhand eines Ausführungsbeispiels im Zusammenhang mit einer Zeichnungsfolge erläutert werden. Es zeigen die
- Fig. 1a- e: ein schematisierter Ablauf eines Herstellungsprozesses für einen Silizium-Wafer der eine isolierende Zwischenschicht und daran anschließende vergrabene silizidierte Bereiche aufweist.

Die in Figur 1a-e dargestellte Folge von Prozeßschritten zeigt den Herstellungsprozess für einen Wafer 100 mit einer isolierenden Zwischenschicht 405 aus Siliziumoxid (SOl-Wafer), der vergrabene silizidierte Bereiche 414 aufweist. Die ganzflächige Zwischenschicht 405 isoliert die oberste monokristalline Siliziumschicht elektrisch von dem Trägermaterial 410, wobei die Schichtdicke der obersten Siliziumschicht und der isolierenden Zwischenschicht 405 entsprechend der späteren Anwendung gewählt werden und vorzugsweise im Bereich bis wenigen µm liegen. Derartige SOl-Wafer werden beispielsweise als Ausgangsmaterial für die Herstellung von substratstromfreien integrierten Schaltungen verwendet, wobei unterschiedliche Gattungen von Bauelementen auf einem SOI-Wafer integriert werden. Im Folgenden wird der Herstellungsprozeß im Einzelnen erläutert.

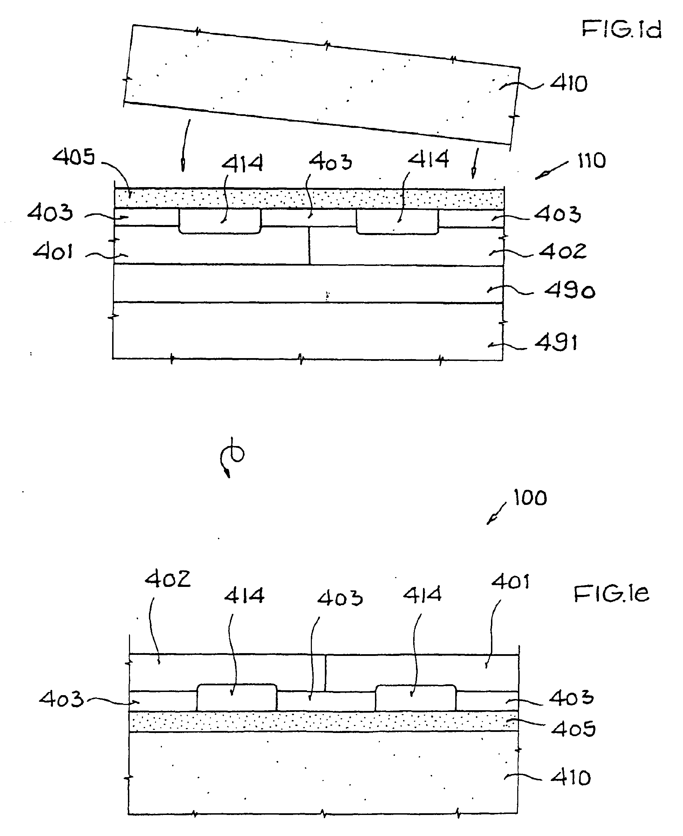

Die Figur 1a zeigt einen Querschnitt eines ersten SOI-Wafers 110. Der SOI-Wafer 110 weist einen Träger 491 aus Silizium auf, an den sich eine Oxidschicht 490 als isolierende Schicht, deren Dicke vorzugsweise zwischen 0.1 µm und 2.0 µm liegt, anschließt. An die Oxidschicht 490 schließt sich eine Schicht aus Silizium an, die mittels einer Implantation in einen ersten Bereich 401 mit einer ersten Leitfähigkeit und einen zweiten Bereich 402 mit einer zweiten Leitfähigkeit aufgeteilt ist.
In einem nachfolgenden Schritt, dargestellt in Figur 1b, wird auf der Oberfläche des SOI-Wafers 110 eine ganzflächige Oxidschicht 403 aufgebracht, in der mittels eines Maskenschrittes Öffnungen geätzt werden, in denen durch einen nachfolgenden Prozeßschritt ein Silizid 414 erzeugt wird. Die Dicke der Oxidschicht 403 wird dabei so gewählt, daß sie zusammen mit den silizidierten Bereichen 414 eine planare Oberfläche bildet.
In einem nachfolgenden Prozessschritt, dargestellt in Figur 1c, wird eine Oxidschicht 405 mittels eines Abscheidungsprozesses aufgebracht, deren Dicke vorzugsweise im Bereich oberhalb 0.1 µm liegt. Die genaue Oxiddicke bestimmt sich aus der Art der späteren Anwendung.
In einem nachfolgenden Prozeßschritt, dargestellt in Figur 1d, wird die Oberfläche des SOI-Wafers 110 mit der Oberfläche eines zweiten Wafers 410, der aus Kostengründen keine isolierende Oxidschicht aufweist, zusammengefügt (bonden). Eine wichtige Voraussetzung hierfür ist, daß beide Wafer 110, 410 eine weitestgehend planare Oberfläche aufweisen, d.h. weder konkav noch konvex verspannt sind.
In Figur 1e ist der Querschnitt des fertigen SOl-Wafers 100 dargestellt, wobei der Träger 491 und die Oxidschicht 490 des ersten SOI-Wafers 110 entfernt wurden. Die Entfernung des Trägers 491 geschieht vorzugsweise in einer Kombination aus einem chemischmechanischen Polierschritt und einem nasschemischen Ätzschritt, wobei der naßchemische Prozeßschritt eine Selektivität in der Ätzrate zwischen Silizium und Oxid aufweist.

Mit dem erfindungsgemäßen Verfahren lassen sich vorteilhaft Bereiche mit unterschiedlichen Schichteigenschaften, wie beispielsweise Dotierung, Silizidierung, usw. durch standardisierte Fertigungsverfahren innerhalb eines Herstellungsprozesses für integrierte Schaltungen auf oder innerhalb einer Schicht erzeugen. Dabei können die Parameter der einzelnen Bereiche für die herzustellenden Bauelemente optimiert werden. Durch das anschließende Zusammenfügen der Oberfläche des ersten Wafers 110 mit der Oberfläche des zweiten Silizium-Wafers 410 werden die Bereiche vergraben, wobei beispielsweise vergrabene vertikale Profile in den einzelnen Bereichen hergestellt werden. Damit werden nur an den vorgegebenen Stellen auf dem SOI-Wafer 100 die gewünschten Schichteigenschaften hergestellt. Aufwendige Trenchprozesse zum Durchtrennen von Silizidschichten entfallen. Ferner wird die saubere und defektfreie Oberfläche des ersten Wafers 110 als Ausgangsfläche für nachfolgenden Herstellungsverfahren zur Verfügungen gestellt. Weitere Nachbehandlungsschritte, um eine ausreichenden Oberflächenqualität zu erreichen, entfallen. Des Weiteren lassen sich anstelle einer einzelnen Oxidschicht 401 auch unterschiedliche Schichtaufbauten, beispielsweise Kombinationen aus Nitrid-, Polysilizium- und Oxidschichten erzeugen, die gemeinsam eine isolierende Zwischenschicht bilden.

## Patentansprüche

1. Verfahren zur Herstellung eines Silizium-Wafers (100), wobei ein erster Silizium-Wafer (110), der
- einen Träger (491)
- eine auf dem Träger (491) angeordnete isolierende Zwischenschicht (490), insbesondere eine Siliziumoxidschicht,
- und eine an die Zwischenschicht (490) anschließende Oberflächenschicht (401, 402), insbesondere Silizium, umfasst,
und ein zweiter Silizium-Wafer (410), der eine Oberfläche aufweist,
über ihre jeweilige Oberfläche zusammengefügt werden (bonden),
wobei
vor dem Zusammenfügen auf dem ersten Wafer (110) innerhalb oder auf der Oberfläche der Oberflächenschicht (401, 402), Bereiche (414) mit veränderten Schichteigenschaften erzeugt werden, die sich in wenigstens einer charakteristischen Schichteigenschaft von den diese Bereichen umgebenden Gebiete unterscheiden (403), und
anschließend auf der Oberfläche wenigstens eines Silizium-Wafers (110, 410) wenigstens eine isolierende Schicht, insbesondere Siliziumoxid (405), aufgebracht wird, und
nach dem Zusammenfügen der beiden Silizium-Wafer (110, 410) der Träger (491) des ersten Silizium-Wafers (110) entfernt wird.

2. Verfahren nach Anspruch 1, **dadurch gekennzeichnet, dass** bei dem ersten Wafer (110) der Träger (491) selektiv zu der isolierenden Zwischenschicht (490) entfernt wird.

3. Verfahren nach Anspruch 2, **dadurch gekennzeichnet, dass** die isolierende Zwischenschicht (490) des ersten Wafers entfernt wird.

4. Verfahren nach Anspruch 1 bis 3, **dadurch gekennzeichnet, dass** als charakteristische Schichteigenschaft die Leitfähigkeit in den Bereichen (414) geändert wird.

5. Verfahren nach Anspruch 4, **dadurch gekennzeichnet, dass** die Leitfähigkeit durch Erzeugung eines Silizides, vorzugsweise eines Kobaltsilizides, geändert wird.

6. Verfahren nach Anspruch 5, **dadurch gekennzeichnet, dass** die Erzeugung des Silizides mittels einer Oxidmaske durchgeführt wird.

7. Verfahren nach Anspruch 6, **dadurch gekennzeichnet, dass** die Dicke der Oxidmaske (403) derart gewählt wird, dass mit der Silizid-Schicht (414) eine planare Fläche entsteht.

8. Verfahren nach Anspruch 7, **dadurch gekennzeichnet, dass** die Oxidschicht (403) und die Silizid-Schicht (414) mit einer isolierenden Schicht (405), vorzugsweise aus Oxid abgedeckt werden.

9. Verfahren nach Anspruch 8, **dadurch gekennzeichnet, dass** das Oxid zur Abdeckung durch Abscheidung erzeugt wird und dessen Schichtdicke vorzugsweise oberhalb 0.5 µm liegt.

10. Verfahren nach Anspruch 9, **dadurch gekennzeichnet, dass** die Oberfläche der Oxidschicht vorzugsweise durch einen chemisch mechanischen Polierschritt (CMP) planarisiert wird.

## Claims

1. Method of producing a silicon wafer (100), wherein a first silicon wafer (110), which comprises
- a carrier (491),
- an insulating intermediate layer (490), particularly a silicon oxide layer, arranged on the carrier (491) and
- a surface layer (401, 402), particularly silicon, connected with the intermediate layer (490),
and a second silicon wafer (410), which has a surface, are joined together (bonded) by way of their respective surfaces,
wherein prior to the joining together there are produced on the first wafer (110), within or on the surface of the surface layer (401, 402), regions (414) with changed layer properties which differ in at least one characteristic layer property from the areas (403) surrounding these regions and subsequently at least one insulating layer, particularly silicon oxide (405), is applied to the surface of at least one silicon wafer (110, 410) and after joining together of the two silicon wafers (110, 410) the carrier (491) of the first silicon wafer (110) is removed.

2. Method according to claim 1, **characterised in that** in the first wafer (110) the carrier (491) is removed selectively with respect to the insulating intermediate layer (490).

3. Method according to claim 2, **characterised in that** the insulating intermediate layer (490) of the first wafer is removed.

4. Method according to claim 1 to 3, **characterised in that** as characteristic layer property the conductivity in the regions (414) is changed.

5. Method according to claim 4, **characterised in that** the conductivity is changed by producing a silicide, preferably a cobalt silicide.

6. Method according to claim 5, **characterised in that** the production of the silicide is carried out by means of an oxide mask.

7. Method according to claim 6, **characterised in that** the thickness of the oxide mask (403) is selected in such a manner that a planar surface arises with the silicide layer (414).

8. Method according to claim 7, **characterised in that** the oxide layer (403) and the silicide layer (414) are covered by an insulating layer (405), preferably of oxide.

9. Method according to claim 8, **characterised in that** the oxide for covering is produced by deposition and the layer thickness thereof is preferably above 0.5 microns.

10. Method according to claim 9, **characterised in that** the surface layer is planarised preferably by a chemical-mechanical polishing step (CMP).

## Revendications

1. Procédé de fabrication d'une plaquette au silicium (100), selon lequel une première plaquette au silicium (110), comprenant :
• un support (491)
• une couche intermédiaire (490) isolante disposée sur le support (491), en particulier une couche d'oxyde de silicium,
• et une couche de surface (401, 402) juxtaposée à la couche intermédiaire (490), plus particulièrement du silicium,
et une deuxième plaquette au silicium (410) présentant une surface,
sont réunies (par bonding) par chacune de leurs surfaces respectives,
selon lequel,
avant la réunion, on produit sur la première plaquette (110), à l'intérieur ou sur la surface de la couche de surface (401, 402), des zones (414) à propriétés de couches modifiées, se distinguant des régions (403) entourant ces zones par au moins une propriété de couche caractéristique, et
on applique ensuite sur la surface d'au moins une plaquette au silicium (110, 410) au moins une couche isolante, plus particulièrement une couche d'oxyde de silicium (405), et
après la réunion des deux plaquettes au silicium (110, 410), on enlève le support (491) de la première plaquette au silicium (110).

2. Procédé selon la revendication 1, **caractérisé en ce que** pour la première plaquette (110), on enlève le support (491) de manière sélective par rapport à la couche intermédiaire isolante (490).

3. Procédé selon la revendication 2, **caractérisé en ce que** l'on enlève la couche intermédiaire isolante (490) de la première plaquette.

4. Procédé selon la revendication 1 à 3, **caractérisé en ce que** l'on modifie la conductivité dans les zones (414) comme propriété caractéristique de la couche.

5. Procédé selon la revendication 4, **caractérisé en ce que** l'on modifie la conductivité en produisant un silicide, de préférence un silicide de cobalt.

6. Procédé selon la revendication 5, **caractérisé en ce que** la production du silicide est effectuée au moyen d'un masque d'oxyde.

7. Procédé selon la revendication 6, **caractérisé en ce que** l'épaisseur du masque d'oxyde (403) est choisie de manière à ce que la couche de silicide (414) permette de former une surface planaire.

8. Procédé selon la revendication 7, **caractérisé en ce que** la couche d'oxyde (403) et la souche de silicide (414) sont recouvertes d'une couche isolante (405), de préférence d'oxyde.

9. Procédé selon la revendication 8, **caractérisé en ce que** l'on produit l'oxyde destiné au recouvrement par précipitation et **en ce que** l'épaisseur de sa couche est de préférence supérieure à 0,5 µm.

10. Procédé selon la revendication 9, **caractérisé en ce que** la surface de la couche d'oxyde est rendue plane par un polissage chimico-mécanique (CMP).
